# EUROPÄISCHE PATENTSCHRIFT

(11) **EP 2 063 666 B1**
(45) Veröffentlichungstag und Bekanntmachung des Hinweises auf die Patenterteilung: **24.04.2019**
(21) Anmeldenummer: 08166874.1
(22) Anmeldetag: 17.10.2008
(51) Int. Cl.: H04R 25/00, H05K 1/02

(54) **Abschirmungseinrichtung für ein Hörhilfegerät**
Shielding device for a hearing aid
Dispositif de blindage pour prothèse auditive

(30) Priorität: 20.11.2007 DE 102007055385
(43) Veröffentlichungstag der Anmeldung: 27.05.2009
(73) Patentinhaber: Sivantos Pte. Ltd., Singapore 539775 (SG)
(72) Erfinder: Koo, Wee Haw, 680294, Singapore (SG); Lim, Meng Kiang, 310060, Singapore (SG)
(74) Vertreter: FDST Patentanwälte

(56) Entgegenhaltungen:
- US-A- 4 922 059
- US-A- 5 031 027
- US-A1- 2005 041 399

## Beschreibung

Die Erfindung betrifft eine Abschirmungseinrichtung für ein Hörhilfegerät und ein Hörhilfegerät mit einer solchen Einrichtung.

Aus dem Stand der Technik, wie er in der DE 602 09 161 T2 offenbart ist, ist beispielsweise ein digitales Hörgerät bekannt. Das Hörgerät weist dabei eine integrierte Schaltung (IC) auf. Auf der integrierten Schaltung (IC) befinden sich dabei viele Schaltungsblöcke bzw. Systemelemente. Dazu gehören beispielsweise ein Regler, ein Lautstärkenregler A/D, eine Schnittstellen-/Systemsteuerung, ein EE-PROM-Speicher, eine Einschalt-Rücksetzschaltung und ein Oszillator/Systemtakt. Des Weiteren weist das Hörgerät mehrere externe Komponenten auf, wie beispielsweise zwei Mikrofone, eine Tele-Spule, ein Lautstärkeregelungspotentiometer, einen Speicherauswahlumschalter, Batterieanschlüsse und einen Lautsprecher. Schall wird hierbei von den beiden Mikrofonen empfangen und in elektrische Signale umgewandelt, die an Eingänge der integrierten Schaltung angekoppelt werden. Die Tele-Spule ist hierbei eine Einrichtung, die magnetisch an einen Telefonhörer angekoppelt wird und einen zum Telefonsignal proportionalen Eingangsstrom erzeugt. Sie dient dazu, akustische Rückkopplungen in das System beim Sprechen am Telefon zu verhindern.

Das zuvor beschriebene Hörgerät hat jedoch den Nachteil, dass beispielsweise ungewollte magnetische Beeinflussungen durch die Tele-Spule entstehen können. Des Weiteren können Störgeräusche durch den Oszillator als Taktgeber entstehen.

Aus der DE 10 2004 051 226 B3 ist des Weiteren ein Hörhilfegerät bekannt, das ein Mikrofon zur Aufnahme eines akustischen Eingangssignals und zur Wandlung in ein elektrisches Signal aufweist. Dieses wird dann zur Weiterverarbeitung und Verstärkung einer als Hybrid-Bauelement ausgebildeten Signalverarbeitungseinheit zugeführt. Das Hörhilfegerät umfasst dabei eine Antenne bzw. Spule zur drahtlosen Übertragung elektromagnetischer Signale zwischen dem Hörhilfegerät und einem weiteren Gerät, beispielsweise eine zweiten Hörhilfegerät zur binauralen Versorgung des Benutzers. Dabei sind um das Hybrid-Bauelement sowie die Antenne jeweils Leitungsschleifen gelegt, so dass von Versorgungsleitungen bzw. Bauelementen hervorgehende elektromagnetische Störfelder am Ort der Antenne bzw. Spule kompensiert werden.

Die Druckschrift DE 199 04 105 C1 offenbart ein Hörgerät mit einer abgeschirmten Schaltungsanordnung. Die Schaltungsanordnung umfasst eine Halbleiterbaugruppe, die mehrseitig gegen elektromagnetische Störstrahlung abgeschirmt ist. Die Schaltungsanordnung ist als Multilayer-Platine ausgeführt und umfaßt einen Layer mit abschirmender Wirkung, der die Halbleiterbaugruppe abdeckt.

Aus der Druckschrift DE 195 44 345 C1 ist ein Hörgerät bekannt, das aktive Bauelemente in einer Verstärker- und Übertragungsschaltung umfasst. Zur Verbesserung der Störsicherheit gegen hochfrequente elektromagnetische Störsignale ist eine elektromagnetische Abschirmung vorgesehen.

Aus der Druckschrift EP 0 852 451 A2 ist ein Hörhilfegerät bekannt, das eine Multilayer-Leiterplatte umfasst. Diese ist zur elektromagnetischen Abschirmung der Schaltungsanordnung mit einer potentialbildenden Masse überzogen.

Ferner ist aus der US 2005/041399 A1 eine Abschirmungseinrichtung auf dem Gebiet der implantierbaren medizinischen Vorrichtungen bekannt, welche wenigstens drei Abschnitte aufweist, wobei um den ersten Abschnitt die beiden anderen Abschnitte herumfaltbar sind, um den ersten Abschnitt abzuschirmen. Dabei bildet eine zuvor festgelegte Oberfläche der Leiterplatine eine Art Stecksystem aus. Die US 2005/041399 A1 offenbart somit lediglich eine faltbare Leiterplatine, die auf einer Seite wenigstens ein Bauteil und/oder eine Schaltung aufweist. Als nachteilig erweist sich hierbei, dass die Leiterplatine ein einzelnes Band umfasst, welches auf einer Seite zusätzliche Komponenten aufweist und nach einem zuvor festgelegten Stecksystem zusammenfaltbar und dadurch sehr unflexibel ist.

Weitere Abschirmungseinrichtungen sind aus den Druckschriften US 4 922 059 A und US 5 031 027 A bekannt.

Aufgabe der Erfindung ist es eine Abschirmungseinrichtung für ein Hörhilfegerät bereitzustellen, welches Bauteile nach außen gegen Störeinflüsse abschirmen kann und umgekehrt.

Erfindungsgemäß wird diese Aufgabe gelöst, indem eine Abschirmungseinrichtung gemäß Anspruch 1 bereitgestellt wird.

Die Abschirmungseinrichtung hat dabei den Vorteil, dass der erste Abschnitt, der beispielsweise mit wenigstens einem SMD-Bauteil oder einer integrierten Schaltung bestückt werden kann, nach außen gegen Störeinflüsse abgeschirmt werden kann, durch den um ihn herumgefalteten zweiten und dritten Abschnitt. Gleichzeitig können die Bauteile bzw. die integrierte Schaltung auf dem ersten Abschnitt so nach außen abgeschirmt werden, dass sie keine Störeinflüsse auf die Umgebung ausüben. Beispielsweise kann ein Oszillator als Taktgeber und Teil der integrierten Schaltung Störgeräusche verursachen, die durch die Abschirmungseinrichtung zumindest reduziert werden.

Gemäß der Erfindung weist die Abschirmungseinrichtung wenigstens ein durchgehendes Band oder zwei oder mehr übereinander angeordnete durchgehende Bänder auf. Die Bänder bilden dabei wenigstens drei Abschnitte von denen wenigstens einer eine gedruckte Leiterplatte auf wenigstens einer Seite aufweist. Zwischen den drei Abschnitten ist jeweils ein Verbindungsabschnitt vorgesehen. Dieser dient dazu, die Abschnitte in diesem Bereich umzufalten bzw. um den ersten Abschnitt herumzufalten. Das Band bzw. die Bänder haben den Vorteil, dass sie leicht und kostengünstig in der Herstellung sind. Bei mehreren Bändern ist dabei jeweils eine Isolierschicht oder dielektrische Schicht dazwischen angeordnet.

Gemäß der Erfindung sind auf wenigstens einer oder beiden Seiten des Bandes bzw. auf wenigstens einer oder beiden Außenseiten der Bänder zusätzlich wenigstens ein oder zwei Lagen von Bändern angeordnet. Die Bänder einer Lage sind dabei so dimensioniert und positioniert, dass sie die jeweiligen Abschnitte der Abschirmungseinrichtung bilden, während die flexiblen Verbindungsabschnitte frei bleiben. Auf diese Weise kann die Abschirmungseinrichtung im Bereich der Abschnitte mit einer festeren Struktur ausgebildet werden, während die Verbindungsabschnitte flexibel bleiben. Zwischen den Bändern ist dabei jeweils eine Isolierschicht vorgesehen, wobei die Isolierschichten zwischen den Bändern beliebig variiert werden können hinsichtlich Material und Dicke, je nach Funktion bzw. Einsatzzweck.

Gemäß einer weiteren erfindungsgemäßen Ausführungsform weist die jeweilige Isolierschicht beispielsweise ein Kunststoffmaterial, zum Beispiel Polyimide oder LCP (Liquid Crystal Polymer), oder ein faserverstärktes Material, wie beispielsweise ein Glasfasermaterial, auf. Je nachdem, ob die Abschirmungseinrichtung flexibel oder teilweise flexibel ausgebildet werden soll, werden entweder nur Isolierschichten aus einem Kunststoffmaterial, z.B. Polyimid, verwendet oder bei einer teilweise flexiblen Abschirmungseinrichtung wenigstens eine Isolierschicht beispielsweise aus Glasfasermaterial. Bei einer starren Abschirmungseinrichtung können beispielsweise nur im Bereich der flexiblen Verbindungsabschnitte Isolierschichten aus Materialien wie z.B. Polyimid verwendet werden. Auf diese Weise kann sehr einfach der Grad der Flexibilität der Abschirmungseinrichtung gesteuert werden.

In einer weiteren erfindungsgemäßen Ausführungsform werden die Bänder bzw. die Abschnitte und Verbindungsabschnitte aus Metall oder einer Metalllegierung hergestellt, die eine geeignete Abschirmung beispielsweise gegen magnetische, elektrische und/oder elektromagnetische Einflüsse bereitstellt. Die Bänder können dabei beispielsweise Kupfer oder Gold oder eine entsprechende Legierung aufweisen oder aus dieser hergestellt sein.

Gemäß der Erfindung sind ein oder beide Abschnitte, die die Ober- und Unterseite der Abschirmungseinrichtung in zusammengefaltetem Zustand bilden, schmäler als der darunter liegende Abschnitt ausgebildet, so dass wenigstens ein Draht an den darunter liegenden Abschnitt anschließbar ist, welcher beispielsweise eine bedruckte Leiterplatte mit wenigstens einem SMD-Bauteil und/oder einer integrierten Schaltung aufweist.

Die Erfindung wird anhand von drei Ausführungsformen in den beigefügten Zeichnungen näher erläutert. Darin zeigt:
- Fig. 1: eine erste Ausführungsform der Abschirmungseinrichtung für ein Hörhilfegerät,
- Fig. 2: eine Seitenansicht der Abschirmungseinrichtung in gefaltetem Zustand,
- Fig. 3: eine perspektivische Ansicht der Abschirmungseinrichtung gemäß Fig. 2,
- Fig. 4: eine schematische Schnittansicht der Abschirmungseinrichtung gemäß Fig. 1, und
- Fig. 5: eine schematische Schnittansicht einer Abschirmungseinrichtung gemäß einer zweiten erfindungsgemäßen Ausführungsform, und
- Fig. 6: eine schematische Schnittansicht einer Abschirmungseinrichtung gemäß einer dritten erfindungsgemäßen Ausführungsform.

In allen Figuren sind gleiche bzw. funktionsgleiche Elemente und Vorrichtungen - sofern nichts anderes angegeben ist - mit denselben Bezugszeichen versehen worden.

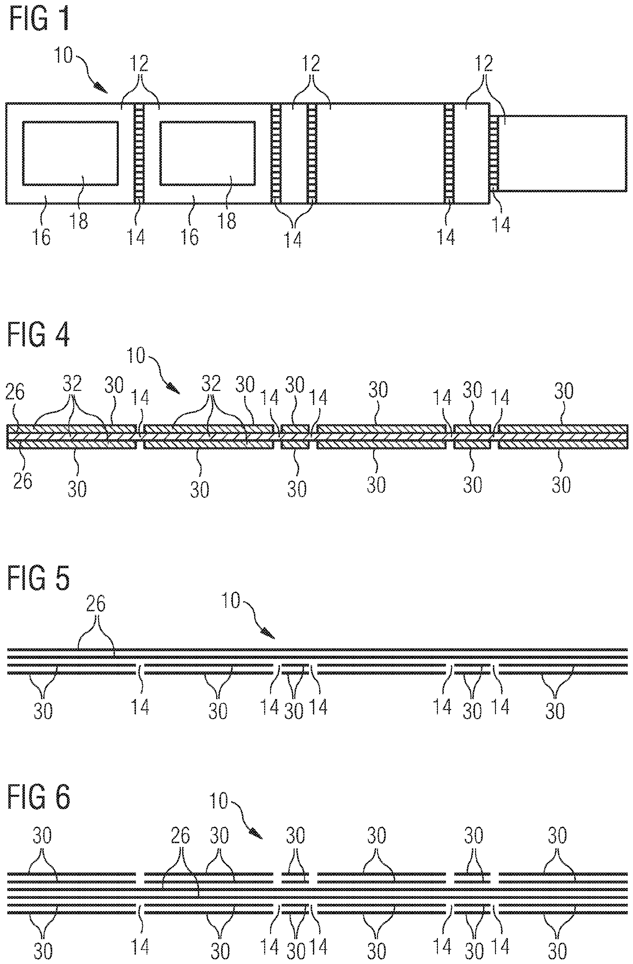

In Fig. 1 ist eine Abschirmungseinrichtung 10 gemäß einer ersten Ausführungsform der Erfindung gezeigt. Die Abschirmungseinrichtung 10 besteht dabei aus mehreren zusammenhängenden Abschnitten 12, die über jeweils einen flexiblen Verbindungsabschnitt 14 miteinander verbunden sind. Die ersten beiden der sechs Abschnitte 12 weisen dabei beispielsweise jeweils auf ihrer Ober- und Unterseite eine bedruckte Leiterplatte (PCB) 16 auf. Auf jeweils einer Leiterplatte 16 eines Abschnitts 12 ist beispielsweise eine integrierte Schaltung (IC) 18 vorgesehen. Auf der anderen Seite des jeweiligen Abschnitts 12 können des Weiteren ein oder mehrere weitere Bauteile 20 auf der dortigen Leiterplatte 16 vorgesehen werden, beispielsweise SMD-Bauteile. Die Abschnitte 12 mit den integrierten Schaltungen 18 und den Bauteilen 20 können dabei eine Art Hybrid-Bauteil bilden. Die Anzahl der bestückten Abschnitte 12 und ihre Bestückung ist dabei lediglich beispielhaft.

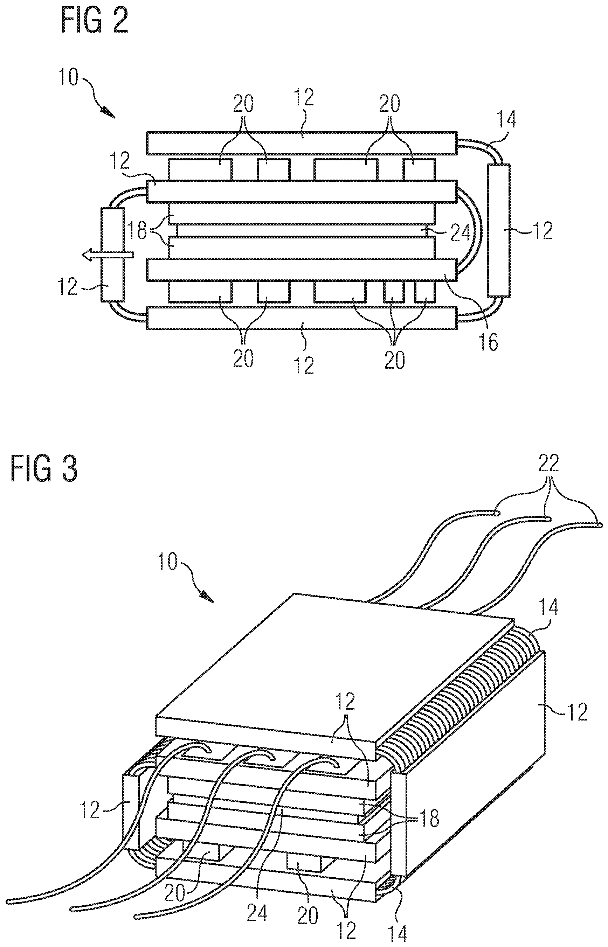

Um nun die integrierten Schaltungen 18 und die übrigen Bauteile 20 nach außen beispielsweise gegen magnetische Störeinflüsse z.B. durch eine Tele-Spule bzw. eine drahtlose Spule (nicht dargestellt) zu schützen, werden die ersten und zweiten Abschnitte 12 mit den bedruckten Leiterplatten 16 aufeinander gefaltet entlang des Verbindungsabschnitts 14. Des Weiteren werden die Abschnitte drei bis sechs um die ersten und zweiten Abschnitte 12 mit den integrierten Schaltungen (IC) 18 und den Bauteilen 20 herumgefaltet, entlang der Verbindungsabschnitte 14, um diese nach außen abzuschirmen. Dabei bilden der dritte und fünfte Abschnitt 12 die Seitenflächen der Abschirmungseinrichtung 10 und der vierte und sechste Abschnitt 12 die Ober- und Unterseite der Abschirmungseinrichtung 10. Auf den Außenseiten des dritten bis sechsten Abschnitts 12 sind dabei beispielsweise keine zusätzlichen Bauteile, wie SMD-Bauteile usw., angeordnet, da sie in erster Linie als Abschirmung gegen ungewollte magnetische, elektrische, elektromagnetische und/oder akustische Einflüsse dienen. Der vierte und/oder sechste Abschnitt 12 wird an einer oder beiden Seiten jeweils etwas schmäler oder mit wenigstens einer Aussparung ausgebildet, um einen ausreichenden Platz frei zu halten, um auf dem ersten bzw. zweiten Abschnitt 12 mit der bedruckten Leiterplatte 16 Drähte bzw. Kabel 22 anschließen zu können, wie in der perspektivischen Ansicht in Fig. 3 gezeigt ist, die im folgenden noch näher erläutert wird.

In Fig. 2 ist die Abschirmungseinrichtung 10 in einer Seitenansicht in zusammengefaltetem Zustand gezeigt. Dabei sind die beiden ersten und zweiten Abschnitte 12 mit den integrierten Schaltungen (IC) 18 aufeinander gefaltet. Zwischen den beiden Abschnitten 12 bzw. den integrierten Schaltungen 18 kann dabei wahlweise zusätzlich eine Trennschicht 24 angeordnet sein. Die Trennschicht 24 kann hierbei beispielsweise aus Schaumstoff oder einem Gummimaterial bestehen. Die Trennschicht 24 dient dazu, dass die beiden integrierten Schaltungen 18 im vorliegenden Fall nicht miteinander in Berührung kommen, um eine mögliche gegenseitige Beschädigung der Schaltungen 18 zu verhindern. Wie zuvor beschrieben, können auf der anderen Seite des ersten bzw. zweiten Abschnitts 12 wenigstens eine oder mehrere weitere Bauteile 20 angeordnet werden und umgekehrt. Solche Bauteile 20 können beispielsweise ein Taktgeber, wie ein Oszillator, sein. Dies ist jedoch lediglich ein Beispiel für eine Vielzahl von Bauteilen 20 die auf den Leiterplatten 16 angebracht werden können. Durch die äußeren Abschnitte 12 werden die integrierten Schaltungen 18 und die anderen Bauteile 20 vor störenden magnetischen, elektrischen, elektromagnetischen und/oder akustischen Einflüssen durch externe Teile geschützt, wie beispielsweise einer Tele-Spule bzw. einer drahtlosen Spule. Des Weiteren können aber auch die externen Teile umgekehrt vor magnetischen, elektrischen, elektromagnetischen und/oder akustischen Einflüssen der Bauteile 20 bzw. Schaltungen 18 der beiden ersten Abschnitte 12 geschützt werden. Beispielsweise können die externen Teile vor Störgeräuschen geschützt werden, die zum Beispiel durch einen Oszillator als Taktgeber erzeugt werden, der beispielsweise Teil der integrierten Schaltung 18 ist.

In Fig. 3 ist die Abschirmungseinrichtung 10 aus Fig. 2 in einer perspektivischen Ansicht gezeigt. Hierbei ist der obere, sechste Abschnitt 12 auf wenigstens einer Seite, bzw. hier auf beiden Seiten, etwas schmäler als der darunter liegende zweite Abschnitt 12 ausgebildet. Auf diese Weise bleibt auf beiden Seiten Platz frei, um Drähte bzw. Kabel 22 an der zweiten Leiterplatte 16 anzuschließen und diese mit der integrierten Schaltung 18 oder anderen Bauteilen 20 zu verbinden. Wahlweise kann auch der untere, vierte Abschnitt 12 so ausgebildet werden, dass auf einer oder beiden Seiten Platz frei bleibt, so dass Drähte bzw. Kabel 22 angeschlossen werden können, um mit dem anderen Abschnitt 12 und dessen integrierter Schaltung 18 oder Bauteilen 20 verbunden zu werden.

Die Abschirmungseinrichtung 10 kann dabei, wie in der ersten Ausführungsform der Erfindung in Fig. 4 gezeigt ist, aus zwei durchgehenden Bändern 26 bestehen und jeweils einer zusätzlichen Lage von Bändern 30 auf jeder Seite. Die zusätzlichen Bänder 30 sind dabei derart dimensioniert und positioniert, so dass sie die sechs Abschnitte 12 der Abschirmungseinrichtung 10 bilden. Zwischen den Bändern 30 wird dabei jeweils ein ausreichender Platz freigelassen, um den flexiblen Verbindungsabschnitt 14 sicherzustellen. Die Bänder 26, 30 können dabei aus Metall bzw. einer Metalllegierung bestehen. Beispielsweise können die Bänder 26, 30 aus Kupfer, Gold usw. oder einer entsprechenden Metalllegierung bestehen. Zwischen den Kupferbändern in Fig. 4 ist eine dielektrische Schicht angeordnet, die als Isolierschicht 32 dient. Wenigstens eine oder alle Abschnitte 12 können dabei im Wesentlichen voll flexibel ausgebildet sein. In diesem Fall ist zwischen den Kupferbändern 26, 30 die Isolierschicht 32 beispielsweise aus Polyimid oder LCP als dielektrischem Material vorgesehen. Sollen dagegen wenigstens eine oder alle Abschnitte 12 teilweise flexibel ausgebildet werden, so wird beispielsweise zwischen den Bändern 30 der oberen Lage und dem durchgehenden Band 26, sowie zwischen den beiden durchgehenden Bändern 26 die Isolierschicht 32 aus einem Kunststoffmaterial, wie Polyimid oder LCP verwendet. Dagegen wird zwischen den Bändern 30 der unteren Lage und dem anderen durchgehenden Band 26 die Isolierschicht 32 aus einem festeren Material, beispielsweise einem Glasfasermaterial, gewählt. Dies ist jedoch lediglich ein Beispiel von vielen, wie die Isolierschichten 32 vorgesehen werden können. Wie in Fig. 4 stark vereinfacht und nicht maßstäblich dargestellt, kann die Isolierschicht 32 über die gesamte Fläche zwischen den Bändern 26, 30 aufgebracht werden oder nur in Abschnitten der Bänder angebracht werden (nicht dargestellt). Dies gilt für alle Ausführungsformen.

Der jeweilige flexible Verbindungsabschnitt 14 zwischen den Abschnitten 12 wird bereitgestellt, indem ein Teil der Bänder 26 durchgehend ausgebildet wird, d.h. die Bänder 26 bilden sowohl einen Teil der Abschnitte 12, die beispielsweise mit einer oder mehreren bedruckten Leiterplatten 16 versehen werden können, als auch gleichzeitig eine Verbindung der Abschnitte 12 miteinander. Wie in Fig. 4 gezeigt ist, bestehen die flexiblen Verbindungsabschnitte 12 beispielsweise aus zwei durchgehenden Kupferbändern, wobei eine ebenfalls flexible Kunststoffschicht als Isolierschicht 32 dazwischen angeordnet wird.

Die Abschirmungseinrichtung 10 kann dabei beispielsweise von selbst in ihrer gefalteten Form gehalten werden. Wahlweise kann beispielsweise auch eine Klammer (nicht dargestellt) vorgesehen werden, zwischen die die Abschirmungseinrichtung 10 eingeschoben wird. Alternativ ist auch denkbar, beispielsweise den sechsten Abschnitt 12 mit dem zweiten Abschnitt 12 zu verkleben oder zu verlöten. Wahlweise ist auch denkbar, die Abschirmungseinrichtung 10 in eine entsprechende Aufnahme in einem Gehäuse (nicht dargestellt) einzusetzen, in welcher die Abschirmungseinrichtung gehalten wird. Dies gilt für alle Ausführungsformen.

In Fig. 5 ist eine zweite Ausführungsform der erfindungsgemäßen Abschirmungseinrichtung 10 dargestellt. Diese unterscheidet sich von der ersten Ausführungsform durch die Anordnung der Bänder 26, 30. Aus Gründen der Übersichtlichkeit wurden die Bauteile und Schaltungen, die an den Leiterplatten der Abschnitte 12 befestigt werden können weggelassen. Des Weiteren wurde auch die Darstellung der Isolierschicht die zwischen den Bändern 26, 30 angeordnet ist weggelassen. Die Abschirmungseinrichtung 10 weist dabei zwei erste und zweite durchgehende Bänder 26 auf. Auf einer Seite sind zusätzlich zwei Lagen von Bändern 30 vorgesehen, die so dimensioniert und positioniert sind, dass sie die Abschnitte 12 der Abschirmungseinrichtung 10 bilden, die beispielsweise mit wenigstens einer bedruckten Leiterplatte 16 jeweils versehen werden können. Die Bänder 26, 30 sind, wie zuvor bereits mit Bezug auf die erste Ausführungsform beschrieben wurde, aus Metall bzw. einer Metalllegierung, beispielsweise Kupfer. Des Weiteren ist eine Isolierschicht zwischen den Bändern 26, 30 vorgesehen. Die Isolierschicht kann dabei abschnittsweise oder vollflächig zwischen den Bändern 26, 30 aufgetragen werden, wie beispielhaft in Fig. 4 gezeigt ist.

Abhängig davon, ob die Abschnitte 12 flexibel, teilweise flexibel oder starr ausgebildet werden sollen, werden entsprechend einige oder alle Isolierschichten aus Kunststoff, wie Polyimid oder LCP, vorgesehen oder wahlweise eine oder mehrere Isolierschichten beispielsweise aus Glasfasermaterial, wie zuvor bereits detailliert mit Bezug auf Fig. 4 beschrieben wurde.

Des Weiteren ist in Fig. 6 eine dritte erfindungsgemäße Ausführungsform der Abschirmungseinrichtung 10 dargestellt, die sich von der ersten und zweiten Ausführungsform im Wesentlichen durch die Anzahl und Anordnung der Bänder 26, 30 unterscheidet. Diese weist beispielsweise zwei durchgehende Bänder 26 auf und jeweils auf beiden Seiten zwei zusätzliche Lagen mit Bändern 30. Die Bänder 30 sind dabei so dimensioniert und positioniert, dass sie die Abschnitte 12 der Abschirmungseinrichtung 10 bilden und jeweils einen Bereich frei lassen. Die flexiblen Verbindungsabschnitte 14 werden nur durch die durchgehenden Bänder 26 gebildet. Zwischen den Bändern 26, 30 sind die zuvor beschriebenen Isolierschichten (nicht dargestellt) vorgesehen. Die Isolierschichten können dabei, wie bereits mit Bezug auf Fig. 4 beschrieben wurde, so variiert werden, dass die Abschirmungseinrichtung 10 beispielsweise flexibel oder teilweise flexibel ist.

Die Erfindung ist nicht auf die vorliegenden Ausführungsformen beschränkt. Die zuvor beschriebenen Ausführungsformen können miteinander kombiniert werden, insbesondere einzelne Merkmale davon. Des Weiteren können die Anzahl, die Anordnung und Dimensionierung von durchgehenden Bändern 26 und Lagen von Bändern 30 beliebig variiert werden, um Abschnitte 12 bereitzustellen, die über flexible Verbindungsabschnitte 14 miteinander verbunden sind. Ebenso können die Isolierschichten 32 zwischen den Bändern 26, 30 beliebig variiert werden, beispielsweise hinsichtlich Dicke, Material, Verteilung usw..

Die erfindungsgemäße Abschirmungseinrichtung 10 ist für Hörhilfegeräte geeignet, welche beispielsweise Hörgeräte umfassen für Menschen mit Hörproblemen, wie Schwerhörigkeit, sowie jede andere Art von Hörgeräten bzw. Hörhilfegeräten, die zur Übertragung von akustischen Signalen verwendet werden. Dazu gehören beispielsweise sog. Headsets, wie sie bei Handys verwendet werden oder bei Musikabspielgeräten, wie Walkmans oder Mp3-Playern usw.. Die Aufzählung ist jedoch lediglich beispielhaft und nicht abschließend.

## Patentansprüche

1. Abschirmungseinrichtung (10) für ein Hörhilfegerät, wobei die Abschirmungseinrichtung (10) wenigstens drei Abschnitte (12) aufweist, die jeweils über einen flexiblen Verbindungsabschnitt (14) miteinander verbunden sind, wobei wenigstens ein erster Abschnitt (12) mit einer bedruckten Leiterplatte (16) versehen ist und mit wenigstens einem Bauteil (20) und/oder einer integrierten Schaltung (18) bestückbar ist, wobei die beiden anderen Abschnitte (12) mittels der flexiblen Verbindungsabschnitte (14) um den ersten Abschnitt (12) herumfaltbar sind, um den ersten Abschnitt (12) abzuschirmen, wobei die Abschirmungseinrichtung (10) wenigstens ein durchgehendes Band (26) oder zwei oder mehr übereinander angeordnete durchgehende Bänder (26) aufweist und auf wenigstens einer oder beiden Seiten des Bandes (26) bzw. auf wenigstens einer oder beiden Außenseiten der Bänder (26) zusätzlich wenigstens ein oder zwei Lagen an Bändern (30) angeordnet ist, wobei die Bänder (30) einer Lage jeweils die Abschnitte (12) der Abschirmungseinrichtung (10) bilden, **dadurch gekennzeichnet, dass** einer oder beide Abschnitte (12), die die Ober- und Unterseite der Abschirmungseinrichtung (10) in zusammengefaltetem Zustand bilden, wenigstens auf einer oder beiden Seiten schmäler als der darunter liegende Abschnitt (12) ausgebildet sind, so dass wenigstens ein Draht (22) an dem darunter liegenden Abschnitt (12) anschließbar ist.

2. Abschirmungseinrichtung (10) nach Anspruche **1, dadurch gekennzeichnet, dass** zwischen den Bändern (26, 30) jeweils eine Isolierschicht (32) vorgesehen ist.

3. Abschirmungseinrichtung (10) nach Anspruch **2, dadurch gekennzeichnet, dass** die Isolierschichten (32) zwischen den Bändern (26, 30) gleich oder unterschiedlich sind, beispielsweise hinsichtlich des Materials, der Dicke und/oder der Verteilung.

4. Abschirmungseinrichtung (10) nach wenigstens einem der Ansprüche **2 oder 3, dadurch gekennzeichnet, dass** die jeweilige Isolierschicht (32) ein Kunststoffmaterial, zum Beispiel Polyimide oder LCP, oder ein faserverstärktes Material, wie beispielsweise ein Glasfasermaterial, aufweist.

5. Abschirmungseinrichtung (10) nach wenigstens einem der Ansprüche **2 bis 4, dadurch gekennzeichnet, dass** die Isolierschichten (32) zwischen den Bändern (26, 30) in dem Bereich der flexiblen Verbindungsabschnitte (14) aus Kunststoff, beispielsweise Polyimid oder LCP bestehen.

6. Abschirmungseinrichtung (10) nach einem der Ansprüche **1 bis 5, dadurch gekennzeichnet, dass** die Bänder (26, 30) bzw. Abschnitte (12) und Verbindungsabschnitte (14) aus Metall oder einer Metalllegierung bestehen, beispielsweise aus Kupfer oder Gold.

7. Abschirmungseinrichtung (10) nach einem der Ansprüche **1 bis 6, dadurch gekennzeichnet, dass** die Abschirmungseinrichtung (10) sechs Abschnitte (12) aufweist, wobei ein erster und/oder zweiter Abschnitt (12) auf einer oder beiden Seiten wenigstens eine gedruckte Leiterplatte (16) aufweist, wobei die gedruckte Leiterplatte (16) mit wenigstens einer integrierten Schaltung (18) und/oder einem Bauteil (20), beispielsweise einem SMD-Bauteil, bestückbar ist, und wobei wahlweise, beim Aufeinanderfalten der beiden Abschnitte (12) eine Trennschicht (24) dazwischen anordenbar ist.

8. Abschirmungseinrichtung (10) nach Anspruch **7, dadurch gekennzeichnet, dass** die Trennschicht (24) aus einem Schaumstoff- oder Gummimaterial besteht.

9. Abschirmungseinrichtung (10) nach wenigstens einem der Ansprüche **1 bis 8, dadurch gekennzeichnet, dass** die Abschirmungseinrichtung (10) eine Abschirmung ist, um die mit wenigstens einer integrierten Schaltung (18) und/oder einem Bauteil (20), beispielsweise einem SMD-Bauteil, bestückbare Leiterplatte (16) wenigstens eines Abschnitts (12) gegen magnetische, elektrische, elektromagnetische und/oder akustische Einflüsse von außen und/oder nach außen hin abzuschirmen.

10. Hörhilfegerät das wenigstens eine Abschirmungseinrichtung (10) nach wenigstens einem der Ansprüche **1 bis 9** aufweist.

## Claims

1. Shielding device (10) for a hearing aid, wherein the shielding device (10) has at least three sections (12) which are in each case connected to one another by means of a flexible connecting section (14), wherein at least one first section (12) is provided with a printed circuit board (16) and can be populated with at least one component (20) and/or one integrated circuit (18), wherein the two other sections (12) can be folded around the first section (12) by means of the flexible connecting sections (14) in order to shield the first section (12), wherein the shielding device (10) has at least one continuous strip (26) or two or more continuous strips (26) which are disposed one above the other and additionally at least one or two layers of strips (30) is/are disposed on at least one or both outer sides of the strips (26), wherein the strips (30) of a layer respectively form the sections (12) of the shielding device (10), **characterized in that** one or both sections (12), which form the top side and bottom side of the shielding device (10) in the folded-together state, are narrower than the section (12) lying underneath at least on one or both sides, so that at least one wire (22) can be connected to the section (12) lying underneath.

2. Shielding device (10) according to Claim 1, **characterized in that** an insulating layer (32) is provided between the strips (26, 30) in each case.

3. Shielding device (10) according to Claim 2, **characterized in that** the insulating layers (32) between the strips (26, 30) are identical or different, for example in respect of the material, the thickness and/or the distribution.

4. Shielding device (10) according to at least either of Claims 2 and 3, **characterized in that** the respective insulating layer (32) contains a plastic material, for example polyimides or LCP, or a fibre-reinforced material, such as a glass-fibre material for example.

5. Shielding device (10) according to at least one of Claims 2 to 4, **characterized in that** the insulating layers (32) between the strips (26, 30) are composed of plastic, for example polyimide or LCP, in the region of the flexible connecting sections (14).

6. Shielding device (10) according to one of Claims 1 to 5, **characterized in that** the strips (26, 30) or sections (12) and connecting sections (14) are composed of metal or a metal alloy, for example of copper or gold.

7. Shielding device (10) according to one of Claims 1 to 6, **characterized in that** the shielding device (10) has six sections (12), wherein a first and/or second section (12) has at least one printed circuit board (16) on one or both sides, wherein the printed circuit board (16) can be populated with at least one integrated circuit (18) and/or one component (20), for example an SMD component, and wherein, when the two sections (12) are folded up, an isolating layer (24) can selectively be disposed between them.

8. Shielding device (10) according to Claim 7, **characterized in that** the isolating layer (24) is composed of a foam or rubber material.

9. Shielding device (10) according to at least one of Claims 1 to 8, **characterized in that** the shielding device (10) is a shield in order to shield the printed circuit board (16) of at least one section (12), which printed circuit board can be populated with at least one integrated circuit (18) and/or one component (20), for example an SMD component, against magnetic, electrical, electromagnetic and/or acoustic influences from the outside and/or to the outside.

10. Hearing aid which has at least one shielding device (10) according to at least one of Claims 1 to 9.

## Revendications

1. Dispositif de protection (10) pour appareil d'assistance auditive, le dispositif de protection (10) présentant au moins trois parties (12) reliées entre elles par l'intermédiaire d'une partie de liaison (14) flexible, au moins une première partie (12) étant dotée d'une carte (16) de circuit imprimé et pouvant être équipée d'au moins un composant (20) et/ou d'un circuit intégré (18), les deux autres parties (12) pouvant être rabattues au moyen des parties de liaison (14) flexibles autour de la première partie (12) pour protéger la première partie (12), le dispositif de protection (10) présentant au moins une bande (26) ou deux ou plusieurs bandes (26) disposées les unes au-dessus des autres, et au moins une ou deux couches de bandes (30) étant en outre disposées sur au moins un ou sur les deux côtés de la bande (26) ou sur au moins un ou les deux côtés extérieurs des bandes (26), les bandes (30) d'une couche formant chaque fois les parties (12) du dispositif de protection (10), **caractérisé en ce que**
une ou les deux parties (12) qui forment le côté supérieur et le côté inférieur du dispositif de protection (10) en position rabattue sont plus étroites au moins sur un ou sur les deux côtés que la partie (12) située en dessous, de telle sorte qu'au moins un fil (22) peut être raccordé à la partie (12) située en dessous.

2. Dispositif de protection (10) selon la revendication 1, **caractérisé en ce qu'**une couche isolante (32) est prévue respectivement entre les bandes (26, 30).

3. Dispositif de protection (10) selon la revendication 2, **caractérisé en ce qu'**entre les bandes (26, 30), les couches isolantes (32) sont identiques ou différentes par exemple en termes de leur matériau, de leur épaisseur et/ou de leur répartition.

4. Dispositif de protection (10) selon au moins l'une des revendications 2 ou 3, **caractérisé en ce que** la couche isolante (32) respective présente une matière synthétique, par exemple du polyimide ou du LCP, ou un matériau renforcé de fibres, par exemple un matériau renforcé de fibres de verre.

5. Dispositif de protection (10) selon au moins l'une des revendications 2 à 4, **caractérisé en ce qu'**entre les bandes (26, 30), les couches isolantes (32) sont constituées au niveau des parties de liaison (14) flexibles de matière synthétique, par exemple de polyimide ou de LCP.

6. Dispositif de protection (10) selon l'une des revendications 1 à 5, **caractérisé en ce que** les bandes (26, 30) ou les parties (12) et les parties de liaison (14) sont constituées d'un métal ou d'un alliage de métaux, par exemple de cuivre ou d'or.

7. Dispositif de protection (10) selon au moins l'une des revendications 1 à 6, **caractérisé en ce que** le dispositif de protection (10) présente six parties (12), une première et/ou une deuxième partie (12) présentant sur un côté ou sur les deux côtés au moins une carte (16) de circuit imprimé, la carte (16) de circuit imprimé pouvant être équipée d'au moins un composant (20) et/ou d'un circuit intégré (18), par exemple un composant SMD, et une couche de séparation (24) pouvant être disposée sélectivement entre les deux parties (12) lors de leur rabattement.

8. Dispositif de protection (10) selon la revendication 7, **caractérisé en ce que** la couche de séparation (24) est constituée d'un matériau de mousse ou de caoutchouc.

9. Dispositif de protection (10) selon au moins l'une des revendications 1 à 8, **caractérisé en ce que** le dispositif de protection (10) est une protection servant à protéger la carte de circuit (16), pouvant être équipée d'au moins un circuit intégré (18) et/ou d'un composant (20), par exemple un composant SMD, d'au moins une partie (12), contre des influences magnétiques, électriques, électromagnétiques et/ou acoustiques exercées depuis l'extérieur et/ou vers l'extérieur.

10. Appareil d'assistance auditive qui présente au moins un dispositif de protection (10) selon au moins l'une des revendications 1 à 9.
